# EUROPEAN PATENT APPLICATION

(11) **EP 2 073 274 A1**
(43) Date of publication of application: **24.06.2009**
(21) Application number: 08156147.4
(22) Date of filing: 14.05.2008
(51) Int. Cl.: H01L 29/861, H01L 29/36

(54) **Diode**

(30) Priority: 19.12.2007 EP 07150156
(71) Applicant: ABB Technology AG, 8050 Baden (CH)
(72) Inventor: Nistor, Iulian, CH-5413, Birmenstorf (CH); Kopta, Arnost, CH-8045, Zürich (CH); Wikström, Tobias, CH-5704, Egliswil (CH)
(74) Representative: ABB Patent Attorneys

(57) **Abstract**

A diode (1) for fast switching applications comprises a first layer (2) of a first conductivity type with a first main side (21) and a second main side (22) opposite the first main side (21), a second layer (3) of a second conductivity type, which is arranged on the second main side (22), a plurality of first zones (4) of the first conductivity type with a higher doping concentration than the first layer (2) and a plurality of second zones (5) of the second conductivity type, both of which zones are arranged alternately on the first main side (21). A first metal layer (6) is arranged on top of the first and second zones (4, 5) on that side of the zones, which lies opposite the first layer (2), and a second metal layer (7) is arranged on top of the second layer (3) on that side of the second layer (3), which lies opposite the first layer (2). The first layer (2) comprises a first sublayer (23), which is formed by the first main sided part of the first layer (2), and a second sublayer (24), which is formed by the second main sided part of the first layer (2). A third layer (8) of the first conductivity type is arranged between the first and second sublayer (23, 24). This third layer (8) has a higher doping concentration than the first layer (2) and a lower doping concentration than the first zones (4).

## Description

### Technical Field

The invention relates to the field of power electronics and more particularly to a diode and to a method for manufacturing such a diode.

### Background Art

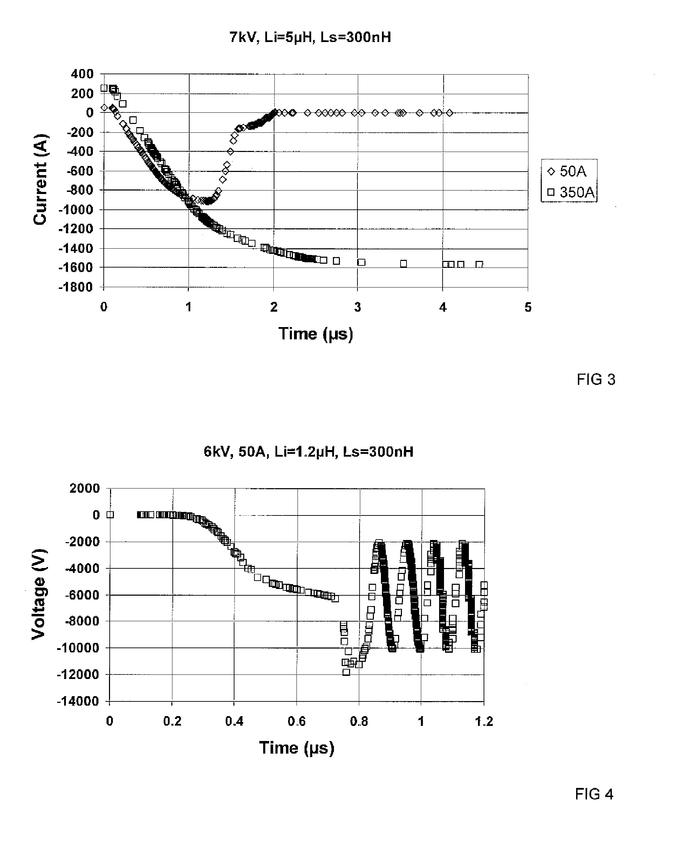

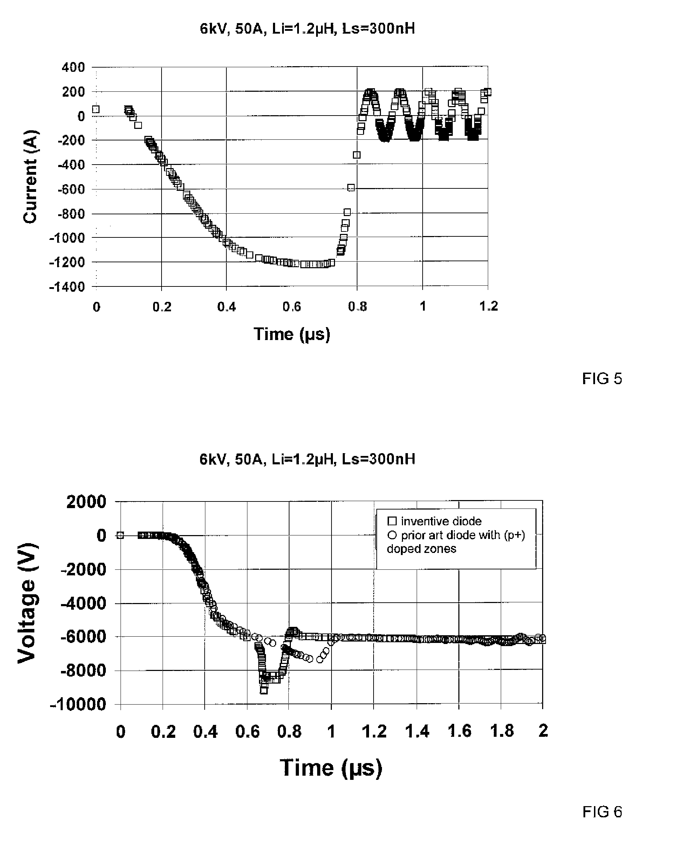

A prior art diode comprises a first n doped layer with a first main side and a second main side opposite the first main side. On the second main side, a second p doped layer is arranged and on top of the p doped layer a metal layer which functions as an anode is arranged. On the first main side, a higher (n+) doped buffer layer is arranged. A first metal layer in form of a cathode is arranged on top of the buffer layer. Figure 4 and 5 show a snappy turn-off effect of such a prior art diode. Fig. 4 shows the over voltages, which arise during the turn-off, and fig. 5 shows the over currents. Such over voltages and current/voltage oscillations are to be avoided in the normal operation of a power electronic system as they can lead to damages and destruction of the diode.

An improvement to the before-mentioned diode is described in DE 36 31 136 A1. In that patent application a fast switching rectifier diode is shown for use at high currents. The diode comprises a first n doped layer 2 with a first main side 21 and a second main side 22 opposite the first main side 21. On the second main side 22, a second p doped layer 3 is arranged and on top of the p doped layer 3 a metal layer which functions as an anode is arranged. On the first main side 21, a higher (n+) doped buffer layer 81 is arranged. On that side of the buffer layer 81, which is opposite the first layer, a plurality of first (n++) doped zones 4 with a higher doping concentration than the first layer 2 and a plurality of second (p+) doped zones 5 are arranged alternately. The area of all p+ zones is 5 % of the complete area. The doping concentration of the buffer layer 81 is such that the space charge region at full blocking voltage extends close to the (p+) doped second zones 5.

The first and second zones 4, 5 are in contact to each other by a first metal layer 6 in form of a cathode, which metal layer is arranged on top of the first and second zones 4, 5, i.e. on the side opposite the buffer layer 81. On top of the second layer 3 a second metal layer 7 is arranged, which has the function of an anode.

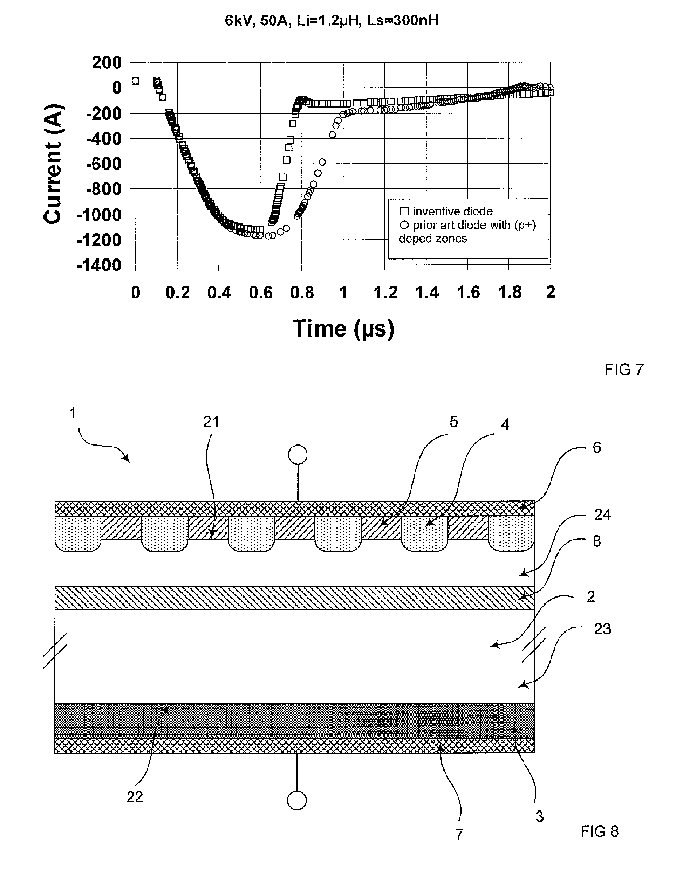

Fig. 6 and 7 show voltage and current during the turn-off for a voltage of 6 kV for a prior art as described in DE 36 31 136 A1, which comprises a plurality of second (p+) doped zones 5 as described above (shown by the circle symbols in both figures). The diode does not show over voltages or over currents as shown in fig. 4 and 5 for a diode without such second (p+) doped zones.

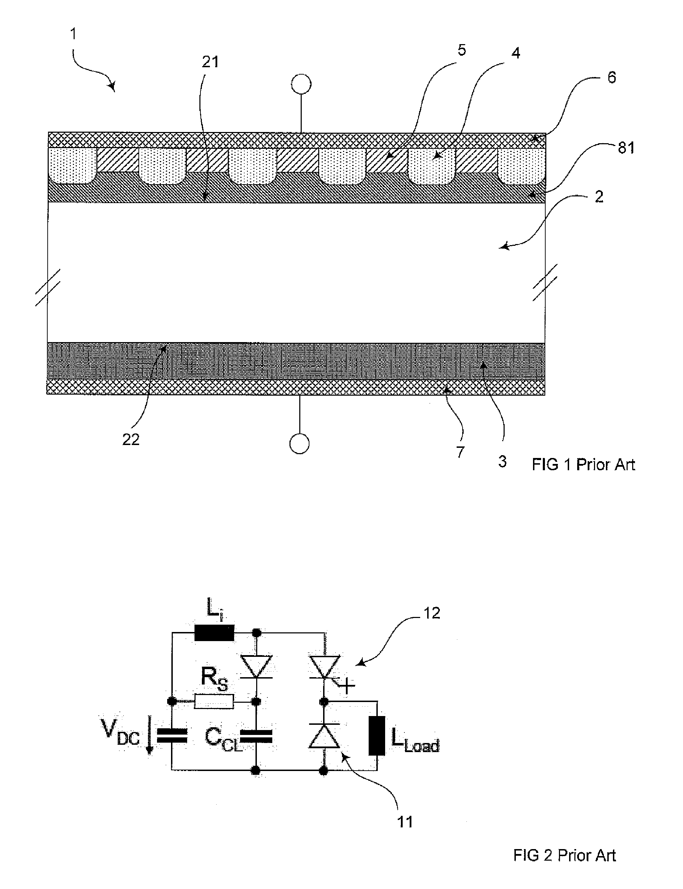

The disadvantage of the diode like the one described in DE 36 31 136 A1, however, is that during the turn-off process, the space charge region extends close to the p+ doped areas. In this way, the lateral flow of electrons from the body of the diode towards the cathode on the surface of the p+ areas is constricted to a very narrow channel. The resistivity of the channel increases as the space charge region continues to expand towards the cathode, and the lateral voltage drop increases accordingly. The second (p+) doped zones start to inject holes when the reverse recovery current reaches a maximum value. Depending on the current, this process can lead to early destruction of the diode. Fig. 3 shows a comparison between a normal turn off process in snap-off conditions (high voltage, low currents, high di/dt, large stray inductance; measuring results with the rhombus symbol in fig. 3) and a second turn-off process in similar conditions but at a higher current (measuring results with the square symbol in fig. 3). The diode design used for these measurements (fig. 3) is of the kind as the prior art diode according to DE 36 31 136, which is schematically shown in fig. 1. In the second case, i.e. for high currents, due to the strong injection of holes through the mechanism detailed above, the current will fail to return to zero and the diode will be destroyed through overheating.

In all circuit topologies associated with power electronic switches as for IGCTs (Integrated gate commutated thyristor) or IGBTs (insulated gate bipolar transistor), the diode plays a critical role as a free wheeling device. Figure 2 shows a simplified circuit including an IGCT 12 switch and clamp circuit. The free wheeling diode 11 is used to create a path for the load current when the IGCT 12 is turned off. When the IGCT 12 is turned-on, the diode will become reverse biased, and will undergo a process called "reverse recovery". The turn-on capability of these switching devices is restricted by the free wheeling diode. Therefore, advanced diode with both high voltage and high recovery performance is desired in high power applications.

During the recovery process, the mobile charge carriers that were flooding the diode in conduction state, have to be removed against the DC link voltage V_{DC}, which can be as high as several kV. If this charge is too large, then a high reverse current will flow through the diode against the high DC link voltage. This increases the diode losses, and the device will fail if the generated heat cannot be removed by a cooling system. On the other hand, if the amount of mobile charge is too small, then the reverse current will snap. The large gradient of the change of current per time that follows can induce dangerous overvoltages and additional electromagnetic noise in the system. Therefore the diode has to be designed with a compromise between low trade-off losses and snappiness. For very high voltages (e.g. 10 kV), the snappiness of the diode becomes even more critical. Such diodes need minimal losses and acceptable cosmic-ray rating, which on the other hand leads to a snappy behaviour.

### Disclosure of Invention

It is an object of the invention to provide a diode for fast switching applications, which is less susceptible for snap-off effects during switch-off of the diode and with lower trade-off losses than the prior art devices and to provide a manufacturing method for such a device.

This object is achieved by a diode according to claim 1 and by a manufacturing method for such a diode according to claim 6 and 8.

The inventive electrical conductor comprises a first layer of a first conductivity type with a first main side and a second main side opposite the first main side, a second layer of a second conductivity type, which is arranged on the second main side, a plurality of first zones of the first conductivity type with a higher doping concentration than the first layer and a plurality of second zones of the second conductivity type, both of which zones are arranged alternately on the first main side. The diode further comprises a first and a second metal layer, the first metal layer being arranged on top of the first and second zones on that side of the zones, which lies opposite the first layer, and the second metal layer being arranged on top of the second layer on that side of the second layer, which lies opposite the first layer. The first layer comprises a first sublayer, which is formed by the first main sided part of the first layer and a second sublayer, which is formed by the second main sided part of the first layer. Between the first and second sublayer a third layer of the first conductivity type is arranged with a higher doping concentration than the first layer and a lower doping concentration than the first zones.

Fig. 6 and 7 show for an inventive diode at a voltage of 6 kV that the turn-off process becomes devoid of artefacts like over voltages or over currents. The current in the final stages of the turn-off process is decreasing slowly, being supported by the injection of holes from the second (p+) doped zones. The inventive diode design presents a so called self switching clamping mode, in which the voltage during the turn-off process remains at a constant voltage without the use of external electrical components. Yet another advantage of the present diode design is a reduced turn-off energy. For the results presented herein the reduction in turn-off energy is approximately 25%, from a value of 4.2 J for the standard buffer structure.

The inventive diode can be advantageously be used as a free-wheeling diode in IGCT (Integrated gate commutated thyristor) or IGBT (insulated gate bipolar transistor) applications.

Further preferred variants and embodiments are disclosed in the dependent patent claims.

### Brief Description of Drawings

The subject matter of the invention will be explained in more detail in the following text with reference to the attached drawings, in which:
- FIG 1: shows a prior art rectifier diode with first (n++) zones and second (p+) doped zones;
- FIG 2: shows a prior art circuit of an IGCT switch and a free wheeling diode;
- FIG 3: shows the current waveforms during the turn-off process under snap off conditions of a prior art rectifier diode with second (p+) doped zones, where the rectifier fails to completely turn-off at low current;
- FIG 4: shows the voltage waveform during the turn-off process under snap off conditions of a prior art diode without second (p+) doped zones;

- FIG 5: shows the current waveform during the turn-off process under snap off conditions of a standard diode without second (p+) doped zones;
- FIG 6: compares the voltage waveforms during the turn-off process under snap off conditions of a prior art diode and the inventive diode, both having second (p+) doped zones;
- FIG 7: compares the current waveforms during the turn-off process under snap off conditions of a prior art diode and the inventive diode, both having second (p+) doped zones.
- FIG 8: shows a first embodiment of a diode according to the invention;
- FIG 9: shows a first manufacturing step for the manufacturing of an inventive diode; and
- FIG 10 to 21: show further manufacturing steps for the manufacturing of an inventive diode.
The reference symbols used in the figures and their meaning are summarized in the list of reference symbols. Generally, alike or alike-functioning parts are given the same reference symbols. The described embodiments are meant as examples and shall not confine the invention.

### Modes for Carrying out the Invention

The further description will be made with a first conductivity type being n type and a second conductivity type being p type, but alternatively the conductivity types can also be reversed.

FIG 2 shows an inventive free-wheeling diode 1 comprising a first layer 2 of a first conductivity type, i.e. of n type, with a first main side 21 and a second main side 22 opposite the first main side 21. A second p doped layer 3 is arranged on the second main side 22. A second metal layer 7 is arranged on top of the second layer 3, i.e. on that side of the second layer 3, which lies opposite the first layer 2. On the first main side 21, a plurality of first (n++) doped zones 4 with a higher doping concentration than the first layer 2 and a plurality of second (p+) doped zones 5, both of which zones are arranged alternately. A first metal layer 6 is arranged on top of the first and second zones 4, 5, i.e. on that side of the zones, which lies opposite the first layer 2. The first layer 2 comprises two sublayers 23, 24. A first sublayer 23 is formed by the first main sided part of the first layer 2. This sublayer comprises the first main side 21 of the first layer 2 and it is arranged adjacent and in contact to the first and second zones 4, 5. A second sublayer 24 is formed by the second main sided part of the first layer 2. This second sublayer 24 comprises the second main side 22 and is arranged adjacent and in contact to the second layer 3. A third (n+) doped layer 8 is arranged between the first and second sublayer 23, 24. This third layer 8 has a higher doping concentration than the first layer 2 and a lower doping concentration than the first zones 4. The third layer 8 in form of a deep buffer layer is arranged closer to the first main side 21 than to the second main side 22.

In a preferred embodiment the area of the all second (p+) doped zones 5 is more than 10 % of the total area.

In another preferred embodiment, the third layer 8 is arranged in a depth from the top of the first and second zones 4, 5, i.e. from the interface between the zones 4, 5 and the first metal layer 6 of 20 to 50 µm. The doping concentration of the third layer 8 is preferably in the range of 10¹⁵ to 10¹⁷ /cm².

In another preferred embodiment, the second zones 5 have a diameter in a range between 50 µm and 400 µm. Preferably, the thickness of the second zones 5 is in a range between 2 µm and 20 µm and/or the doping concentration is in a range between 10¹⁷ and 10¹⁹ /cm².

In another preferred embodiment, the diode 1 is used as a free-wheeling diode 11 for IGCT (Integrated gate commutated thyristor) or IGBT (insulated gate bipolar transistor) applications.

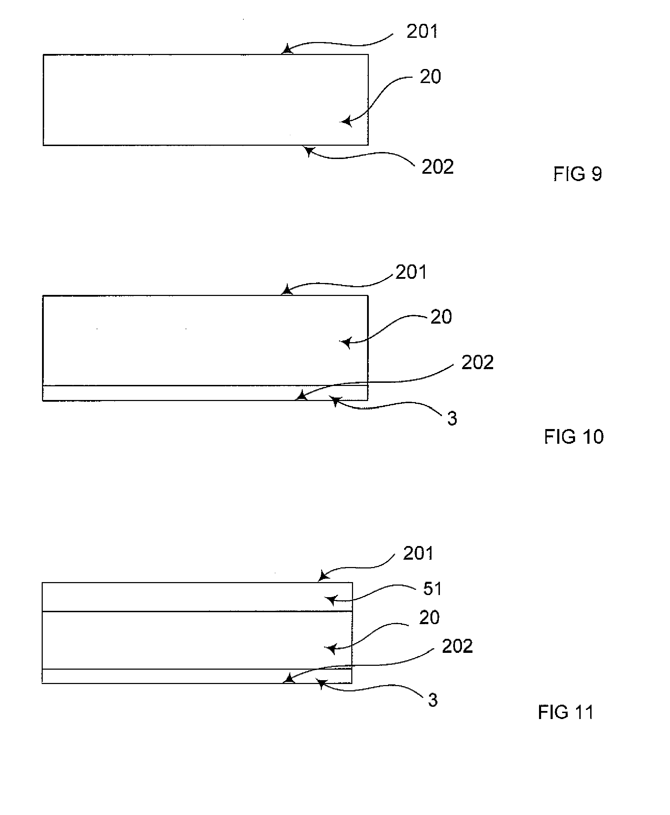

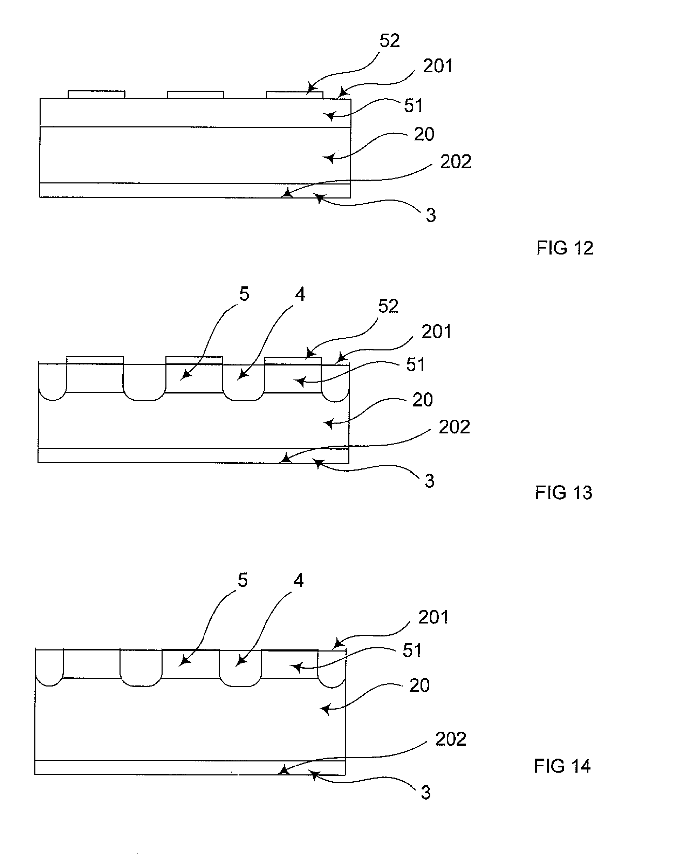

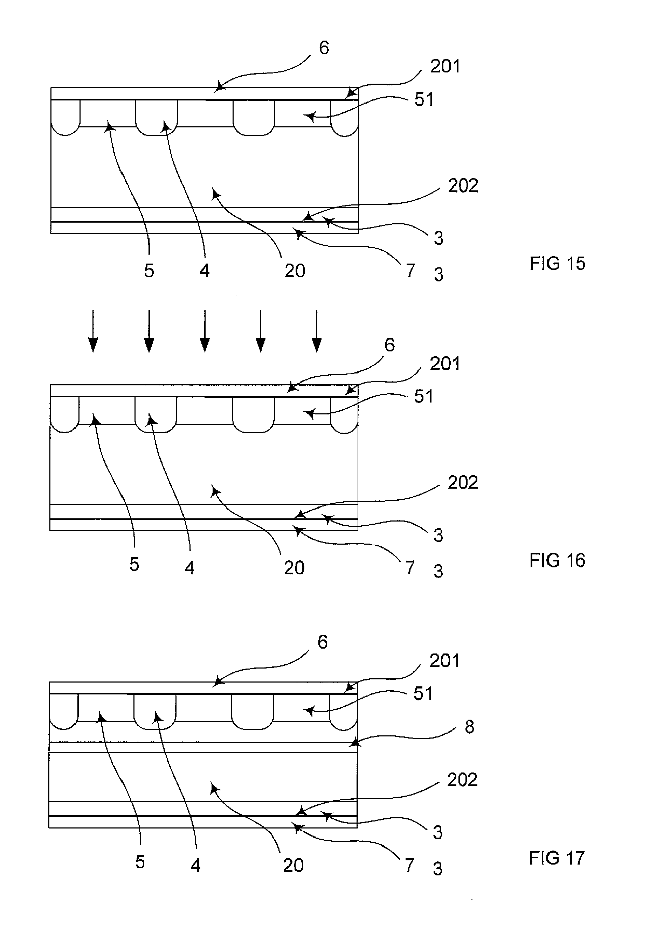

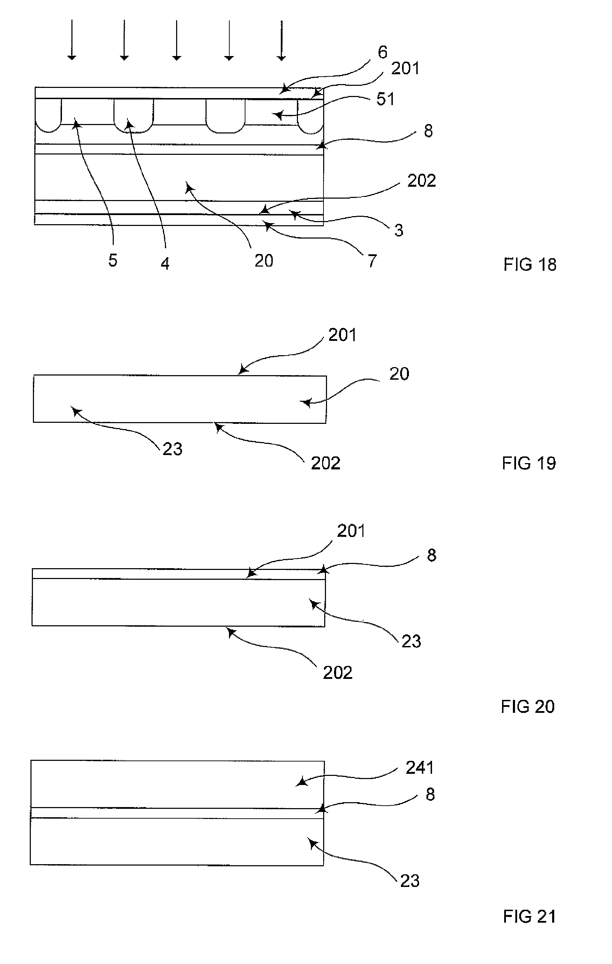

The diode can be manufactured by the following manufacturing method comprising the following steps. An n type wafer 20 is provided with a first side 201 and a second side 202 opposite the first side 201 (fig. 9). For the manufacturing of a pn-junction, on the second side 202 of the wafer 20 the second p type layer 3 is created by a state of the art process of implantation of first ions followed by diffusion at high temperatures (fig. 10). Afterwards the first ions are driven into the wafer 20 up to the desired depth. That is typically done by heating the wafer up to a temperature of 1000 - 1400 °C for several hours. A fourth n type layer 51 is created by implanting second ions into the wafer 20 for the manufacturing of the second zones 5 (fig. 11). Preferably, boron and/or aluminium are used as first ions, and phosphorus is used as second ion. Afterwards the second ions are driven in the wafer by diffusion at high temperature. Then a masking layer 52 is created (fig. 12). That is typically done by applying a photoresist layer on the fourth layer 51 on the first side 201 and afterwards creating the masking layer 52 in that layer. The first n type zones 4 in the fourth layer 51 are created through the masking layer 52, for example by a chemical process, and by drive-in process of the dopants at a lower temperature (fig. 13). Those parts of the fourth layer 51, in which no first zones 4 are created, form the second zones 5. The masking layer 52 is removed (fig. 14), and then typically a metallization process is performed on both sides of the wafer in order to create the first metal layer 6 as a cathode on the first side 201 and the second metal layer 7 as an anode on the second side 202 (fig. 15). An edge termination is made in order to improve the voltage blocking capability of the device. Afterwards the wafer 20 is irradiated with third type ions (fig. 16; represented by the arrows in the figure) for the manufacturing of the third layer 8 from the first side 201 and annealed (fig. 17). Preferably, the third type ions are protons. Energy and concentration of the ions are chosen such that the desired depth and dose concentration of the third layer 8 is achieved. Annealing temperatures are chosen such that the desired n dopant concentration is obtained in the third layer 8. In a further step, the diode 1 may be irradiated with electrons over the whole device in order to further reduce turn-off losses of the device (fig. 18; represented by the arrows in the figure).

Alternatively, the following manufacturing method can be used. An n type wafer 20 is provided with a first side 201 and a second side 202 opposite the first side 201 (fig 19). The wafer 20 forms the first sublayer 23 in the finalized diode 1. A third n type layer 8 with a higher doping than the wafer 20 is epitactically grown on the first side 201 of the wafer 20 (fig. 20). The thickness of this layer is preferably 5 to 20 µm. Afterwards a fifth layer 241 is also epitactically grown on the third layer 8 on the side opposite the first sublayer 23 (fig. 21), typically with a thickness of less than 100 µm. That part of the fifth layer 241, which is not amended in doping by the creation of the first and second zones 4, 5 at a later manufacturing stage forms the first sublayer 23 in the finalized diode 1. After creation of the fifth layer 241, the first and second zones 4, 5 are created in the fifth layer 241 as described above. The second layer 3, the first and second metal layers 6, 7 are also created as described above and an electron irradiation may also be performed in the same manner.

### Reference List

| | |
|---|---|
| diode | 1 |
| first layer | 2 |
| wafer | 20 |
| first side | 201 |
| second side | 202 |
| first main side | 21 |
| second main side | 22 |
| first sublayer | 23 |
| second sublayer | 24 |
| fifth layer | 241 |
| second layer | 3 |
| first zone | 4 |
| second zone | 5 |
| fourth layer | 51 |
| masking layer | 52 |
| first metal layer | 6 |
| second metal layer | 7 |
| third layer | 8 |
| anode | 9 |
| cathode | 10 |

## Claims

1. Diode (1) comprising a first layer (2) of a first conductivity type with a first main side (21) and a second main side (22) opposite the first main side (21), a second layer (3) of a second conductivity type, which is arranged on the second main side (22), a plurality of first zones (4) of the first conductivity type with a higher doping concentration than the first layer (2) and a plurality of second zones (5) of the second conductivity type, both of which zones are arranged alternately on the first main side (21), a first metal layer (6) and a second metal layer (7), the first metal layer (6) being arranged on top of the first and second zones (4, 5) on that side of the zones, which lies opposite the first layer (2), and the second metal layer (7) being arranged on top of the second layer (3) on that side of the second layer (3), which lies opposite the first layer (2), **characterized in that** the first layer (2) comprises a first sublayer (23), which is formed by the first main sided part of the first layer (2), and a second sublayer (24), which is formed by the second main sided part of the first layer (2), and **in that** a third layer (8) of the first conductivity type is arranged between the first and second sublayer (23, 24), the third layer (8) having a higher doping concentration than the first layer (2) and a lower doping concentration than the first zones (4).

2. Diode (1) according to claim 1, **characterized in that** the third layer (8) is arranged in a depth from the top of the first and second zones (4, 5) of 20 to 50 µm and/or **in that** the third layer (8) has a doping concentration in the range of 10¹⁵ to 10¹⁷ /cm².

3. Diode (1) according to claim 1 or 2, **characterized in that** the second zones (5) have a diameter in a range between 50 µm and 400 µm and/or a thickness in a range between 2 µm and 20 µm and/or a doping concentration in a range between 10¹⁷ and 10¹⁹ /cm².

4. Diode (1) according to any of the claims 1 to 3, **characterized in that** the first zones (4) have a diameter in a range between 50 µm and 400 µm and/or a thickness in a range between 2 µm and 20 µm and/or a doping concentration in a range between 10¹⁷ and 10¹⁹ /cm².

5. Integrated gate commutated thyristor or insulated gate bipolar transistor with a diode (1) as a free-wheeling diode according to any of the claims 1 to 4.

6. Method for manufacturing a diode (1) according to any of the claims 1 to 4, the method comprising the following manufacturing steps:
a wafer (20) of the first conductivity type is provided,
a second layer (3) is created by implanting first ions into the wafer (20), afterwards the first ions are driven into the wafer (20),
a fourth layer (51) for the manufacturing of the second zones (5) is created by implanting second ions into the wafer (20),
afterwards the second ions are driven into the wafer (20),
afterwards a masking layer (52) is applied on the fourth layer (51),
afterwards the first zones (4) are created in the fourth layer (51) through the masking layer (52), those parts of the fourth layer (51), in which no first zones (4) are created, forming the second zones (5),
afterwards the wafer (20) is irradiated with third ions for the manufacturing the third layer (8),
afterwards the third ions are annealed, and
the first metal layer (6) and the second metal layer (7) are created at any appropriate manufacturing step.

7. Method for manufacturing a diode according to claim 6, **characterized in that** the first type ions are boron and/or aluminum, the second type ions are phosphorus, and/or the third type ions are protons.

8. Method for manufacturing a diode according to any of the claims 1 to 4, the method comprising the following manufacturing steps:
a wafer (20) of the first conductivity type is provided with a first side (201) and
a second side (202) opposite the first side (201),
the third layer (8) is epitactically grown on the first side (201),
afterwards a fifth layer (241) is grown on the third layer (8), part of which fifth layer (241) forms the second sublayer (24) in the finalized diode (1) and
afterwards the first and second zones (4, 5) are created in the fifth layer (241).

9. Method for manufacturing a diode (1) according to any of the claims 6 to 8, **characterized in that** after the creation of all layers the whole diode (1) is irradiated with electrons.
